Europäisches Patentamt

European Patent Office

Office européen des brevets

(11) Numéro de publication : **0 382 632 B1**

(12)

# FASCICULE DE BREVET EUROPEEN

(45) Date de publication du fascicule du brevet :
**11.10.95 Bulletin 95/41**

(51) Int. Cl.$^6$ : **H01L 31/0392, H01L 31/0224**

(21) Numéro de dépôt : **90400330.8**

(22) Date de dépôt : **07.02.90**

(54) **Substrat transparent électroconducteur à deux couches d'oxydes métalliques, utile notamment dans des dispositifs opto-électroniques.**

(30) Priorité : **08.02.89 JP 29373/89**

(43) Date de publication de la demande :
**16.08.90 Bulletin 90/33**

(45) Mention de la délivrance du brevet :
**11.10.95 Bulletin 95/41**

(84) Etats contractants désignés :
**AT BE CH DE DK ES FR GB IT LI LU NL SE**

(56) Documents cités :
**EP-A- 0 070 509**
**EP-A- 0 234 222**
**US-A- 4 559 552**
**PATENT ABSTRACTS OF JAPAN vol. 8, no.**
**155 (E-256)(1592) 19 juillet 1984 & JP-A-59**
**58874**
**PATENT ABSTRACTS OF JAPAN vol. 12, no.**
**69 (E-587)(2916) 03 mars 1988 & JP-A-62**
**211966**

(73) Titulaire : **SAINT-GOBAIN VITRAGE**
**"Les Miroirs",**
**18 Avenue d'Alsace**
**F-92400 Courbevoie (FR)**

(72) Inventeur : **Shirado, Kyuichi**
**8, Dosho-machi 4-chome**
**Higashi-ku, Osaka-shi, Osaka-fu (JP)**
Inventeur : **Kawahara, Hideo**
**8, Dosho-machi 4-chome**
**Higashi-ku, Osaka-shi, Osaka-fu (JP)**
Inventeur : **Mizonou, Masaro**
**8, Dosho-machi 4-chome**
**Higashi-ku, Osaka-shi, Osaka-fu (JP)**

(74) Mandataire : **Luziau, Nelly et al**
**Saint Gobain Recherche**
**39, Quai Lucien Lefranc**
**BP 135**
**F-93303 Aubervilliers Cédex (FR)**

## Description

La présente invention concerne un substrat électroconducteur transparent, utile notamment comme substrat dans des dispositifs opto-électroniques tels que piles solaires au silicium amorphe et les dispositifs d'affichage à cristaux liquides comme les TFT (Thin Film Transistor = Afficheurs à matrices actives).

Les piles solaires, par exemple, comprennent un élément convertisseur photovoltaïque en silicium amorphe (a-Si) déposé sur un substrat électroconducteur transparent qui sert d'électrode. En général, la couche au silicium amorphe est formée à partir de silane en utilisant la méthode CVD (Chemical Vapor Deposition) assistée par plasma.

Pour former une électrode d'une pile solaire, par exemple, par laquelle pénètre la lumière incidente, il est nécessaire d'utiliser un matériau électroconducteur transparent de faible résistance superficielle et ayant une transmission lumineuse élevée. Comme matériau électroconducteur pour cette électrode, on connait l'oxyde d'indium dopé à l'étain (ITO). Cependant, l'ITO présente certains inconvénients tels qu'une stabilité chimique, comme la résistance aux produits chimiques, insuffisante et une résistance au plasma médiocre.

On peut aussi utiliser de l'oxyde d'étain dopée au fluor ($SnO_2$:F) qui peut atteindre une résistance de 3,5 x $10^{-4}$ $\Omega$.cm environ et une grande stabilité chimique. Cependant, la couche de $SnO_2$:F est aussi dégradée par un plasma réducteur comprenant de l'hydrogène sous forme radicale.

La dégradation de la couche électroconductrice soumise au plasma entraîne une diminution du rendement de la pile solaire.

De la demande de brevet JP-A-5 958 874, il est connu une électrode transparente comportant un substrat de verre, une première couche électroconductrice d'oxyde d'indium dopé à l'étain ITO puis une seconde en oxyde d'étain destinée à protéger la première contre les dégradations liées à l'exposition du substrat à un plasma.

Par ailleurs, de l'abrégé tiré de Patent Abstracts of Japan - vol. 12 - n° 69(E-587) (2916) du 3 mars 1988, est connue une électrode transparente comportant une première couche électroconductrice d'oxyde d'étain dopée au fluor surmontée d'une seconde couche d'oxyde d'étain dépourvue d' halogène excepté le chlore.

La présente invention a pour but un substrat électroconducteur transparent qui présente une résistance élevée au plasma, à savoir une couche qui ne se dégrade pas facilement dans le plasma de silane, et qui est utilisable dans tous dispositifs faisant intervenir un dépôt, sur ce substrat, d'une couche obtenue par utilisation d'un plasma contenant de l'hydrogène sous forme radicale.

Le substrat électroconducteur et transparent, selon l'invention, comprend un support de verre et deux couches transparentes d'oxydes métalliques. La première couche, dite sous-couche, la plus proche du support de verre, est une couche electroconductrice et la deuxième couche, dite surcouche, la plus éloignée du support de verre est une couche dont le composant principal est de l'oxyde d'étain ne contenant pratiquement pas de fluor et dont la teneur en poids de chlore est comprise entre 0,1 et 0,03%.

La sous-couche est une couche électroconductrice d'oxyde d'étain dopé au fluor ou une couche d'oxyde d'indium dopé à l'étain.

Des études sur les relations entre les caractéristiques physiques et la résistance au plasma des couches électroconductrices d'oxyde métallique, en particulier le $SnO_2$:F, ont montré que plus la teneur en fluor dans cette couche de $SnO_2$:F était faible, plus la résistance au plasma était élevée. On a aussi trouve que les résistances au plasma des couches électroconductrices avaient une grande influence sur les performances des dispositifs contenant ces couches, par exemple des piles solaires. Ainsi, une couche de $SnO_2$ dopé au fluor à plus de 0,5 % en poids et présentant une résistance électrique faible s'est avérée mauvaise du point de vue de la résistance au plasma et entraîne un rendement insuffisant des piles solaires. Cependant, la relation entre la teneur en fluor et la résistance au plasma n'est pas encore expliquée.

On a donc pensé à réduire la teneur en fluor dans la couche de $SnO_2$:F pour améliorer la résistance au plasma. Cependant, le dopage de l'oxyde métallique, tel que $SnO_2$, par un dopant comme le fluor permet de diminuer la résistance superficielle de la couche de $SnO_2$. Si la teneur en fluor dans la couche est faible, le nombre de porteurs de charge, dont dépend la conduction électrique, diminue et la résistance superficielle de la couche augmente et les performances des piles solaires sont réduites.

Pour résoudre ce problème, l'invention propose donc un substrat transparent électroconducteur qui comprend, sur le support de verre, une sous-couche électroconductrice, telle que $SnO_2$:F et une surcouche ne comprenant pratiquement pas de fluor. Ainsi, l'invention permet l'utilisation d'une couche électroconductrice de résistance faible, telle que celle utilisée antérieurement, tout en permettant la formation d'un substrat résistant au plasma.

Pour former les couches électroconductrices telles que $SnO_2$:F, il existe plusieurs méthodes, notamment la pyrolyse liquide, le dépôt chimique en phase vapeur (méthode CVD - Chemical Vapor Deposition), la méthode de pulvérisation cathodique, la méthode de trempage, etc... Parmi ces méthodes, pour former la couche

de SnO$_2$:F, on préfère utiliser la méthode CVD qui permet de conférer à la couche d'excellentes caractéristiques. Cette méthode CVD est en outre une méthode économique.

Comme matières premières à base d'étain, que l'on peut utiliser pour cette méthode CVD, on peut citer SnCl$_4$, (C$_n$H$_{2n+1}$)$_4$Sn avec n = 1 à 4, C$_4$H$_9$SnCl$_3$, (CH$_3$)$_2$SnCl$_2$, etc... Comme composé à base de fluor, on utilise avantageusement HF, CCl$_2$F$_2$, CHClF$_2$, CF$_3$Br etc...

Ces matières premières à base d'étain ou de fluor, contiennent du chlore. On sait que le chlore résiduel non encore décomposé est intégré dans la couche.

Le chlore dans la couche de SnO$_2$ contribue à la diminution de la résistance électrique et aussi à une plus grande absorption de la lumière. Il en résulte une diminution de la transmission lumineuse T$_L$. L'absorption de la lumière par les couches électroconductrices diminue la quantité de lumière atteignant la couche de silicium amorphe, ce qui réduit le rendement de conversion en énergie de la pile solaire à base de silicium amorphe.

Pour éviter la diminution de la transmission lumineuse du substrat transparent, on diminue le plus possible la concentration en chlore. Si une teneur faible en chlore était peu envisageable antérieurement puisque cela augmentait la résistance électrique de la couche, il est possible avec le substrat selon l'invention d'obtenir un produit transparent qui présente une bonne conduction de l'électricité par suite de la présence de la sous-couche et une bonne résistance au plasma grâce à la surcouche qui contient peu de fluor et peu de chlore. Pour cela, la couche supérieure du substrat contient une teneur en chlore inférieure à 0,1 % en poids.

L'épaisseur totale des couches de SnO$_2$:F et SnO$_2$ est avantageusement comprise entre 0,4 $\mu$m et 1,0 $\mu$m.

Les exemples suivants, non limitatifs, illustrent l'invention.

## EXEMPLE 1

On lave et on sèche des plaques de verre sodocalcique d'une dimension de 100 x 100 mm et d'une épaisseur de 1,9 mm.

On les utilise comme supports en verre pour former des substrats (1-1 à 1-5) selon l'invention comprenant une sous-couche de SnO$_2$:F et une surcouche de SnO$_2$:Cl contenant des pourcentages différents de chlore.

On dépose sur chacune de ces plaques des couches d'oxydes métalliques, pour former des électrodes, de la façon suivante :

On dépose sur chaque plaque de verre, chauffé à 570°C $\pm$ 5°C, une sous-couche de SnO$_2$:F par la méthode CVD à partir d'un mélange gazeux contenant de la vapeur d'eau, du tétrachlorure d'étain anhydre, de l'oxygène et du gaz 1,1-difluoro-éthane et de l'azote. On obtient une couche de SnO$_2$:F dont l'épaisseur est de 0,6 $\mu$m et la résistance superficielle de 13 $\Omega/\square$ . La teneur en chlore dans la couche de SnO$_2$:F est de 0,30 % en poids.

On dépose ensuite, sur la couche de SnO$_2$:F, une couche de SnO$_2$ d'une faible teneur résiduelle en chlore. Pour cela, on utilise un mélange gazeux contenant de la vapeur d'eau, du tétrachlorure d'étain anhydre, de l'oxygène et du gaz azote, en faisant varier la quantité de vapeur d'eau dans ce mélange. Cela permet d'éliminer le chlore du tétrachlorure d'étain. Les proportions de vapeur d'eau (en mole %) dans le mélange gazeux sont, respectivement, pour les substrats 1-1 à 1-5, de 0,7 ; 1 , 1 ; 2,4 ; 4,5 et 5,4.

On obtient ainsi une couche de SnO$_2$ de 0,3 $\mu$m d'épaisseur.

Le substrat obtenu comprend donc un support de verre, une couche de SnO$_2$:F et une couche superficielle de SnO$_2$ à faible teneur en chlore.

Le tableau 1 indique les teneurs en chlore dans les surcouches de chacun des substrats préparés (mesurées à l'aide d'une microsonde électronique), ainsi que la résistance par carré ($\Omega/\square$) de l'ensemble des deux couches SnO$_2$:F et SnO$_2$. La résistance est mesurée avant le traitement par l'hydrogène.

Pour déterminer la résistance au plasma de ces couches, on expose chacun des substrats à un plasma d'hydrogène. Pour cela, après avoir bien lavé et séché chacun des substrats, on les soumet, pendant 1 mn, à de l'hydrogène sous une pression de 170 Pa, à une température de 220°C au moyen d'un dispositif de décharge luminescente de fréquence de 13,56 MHz du type couplage capacitif avec une puissance de décharge de 24 W.

On mesure la transmission lumineuse des substrats ainsi traités et on examine la variation de la transmission lumineuse T$_L$ avant et après traitement. Cette variation sert à évaluer la résistance au plasma.

Les caractéristiques des substrats sont indiqués au tableau 1. On voit que plus la teneur en chlore dans la surcouche est faible, plus la résistance au plasma est élevée.

Malgré une faible teneur en chlore dans la surcouche, on a pu, grâce à la structure à deux couches d'oxydes métalliques, maintenir la résistance de l'ensemble des deux couches à un faible niveau.

## EXEMPLE 2

Pour préparer 3 substrats (2-1 à 2-3) selon l'invention, on opère comme à l'exemple 1, à la différence que l'on utilise du monobutyltrichlorure-étain ($C_4H_9SnCl_3$) comme composé de l'étain.

On a obtenu des couches de $SnO_2$:F d'une épaisseur de 0,2 μm (substrat 2-1), 0,2 μm (substrat 2-2) et 0,4 μm (substrat 2-3). Sur ces couches de $SnO_2$:F, on dépose des couches de $SnO_2$ à faible teneur en chlore (0,07 % en poids). Ces couches de $SnO_2$ ont une épaisseur de 0,2 μm (substrat 2-1), de 0,4 μm (substrat 2-2) et de 0,2 μm (substrat 2-3).

On leur fait subir le même traitement de plasma qu'à l'exemple 1. On mesure la transmission lumineuse $T_L$ de chacun de ces substrats pour évaluer leur résistance au plasma.

Comme essais témoin, on prépare des substrats A et B comprenant un support de verre et une couche de $SnO_2$:F dont l'épaisseur est respectivement de 0,4 μm et 0,6 μm, mais pas de surcouche. La sous-couche de $SnO_2$:F de chacun des substrats selon l'invention (2-1 à 2-3) et des substrats témoin A et B contiennent une teneur en fluor de 0,64 % en poids et une teneur en chlore de 0,23 % en poids.

On peut constater que le traitement plasma des couches témoin entraîne une grande variation de la transmission lumineuse et donc une résistance au plasma faible .

Le tableau 2 indique les résultats obtenus.

Les exemples précédents montrent que les substrats selon l'invention présentent une transmission lumineuse élevée, une faible résistance électrique et une forte résistance au plasma réducteur.

L'invention a été décrite plus particulièrement avec des couches électroconductrices d'oxyde d'étain dopé au fluor. Les substrats selon l'invention peuvent comprendre, comme couches électroconductrices transparentes, des couches d'oxyde d'indium dopé à l'étain (ITO).

L'utilisation d'une couche d'oxyde d'étain à faible teneur en chlore permet de protéger la couche d'ITO pendant le traitement plasma.

La couche d'ITO peut être obtenue par pyrolyse de poudres de formiate d'indium et d'un composé de l'étain comme le DBTO tel que décrit à la demande de brevet EP-A-192 009 ou bien par pulvérisation cathodique magnétron.

Dans le cas de pyrolyse de poudres, celles-ci sont projetées sur des supports de verre portés à température élevée inférieure à la température de ramollissement du verre, c'est-à-dire à des températures comprises entre 500°C et 750°C. Ces poudres, au contact du verre chaud, se décomposent et s'oxydent pour former la couche d'ITO. Dans le cas de pulvérisation cathodique, la cible est en ITO ou bien elle est constituée d'un alliage des deux métaux, indium et étain.

L'épaisseur des couches d'ITO peut varier entre 20 nm et 500 nm.

Les substrats selon l'invention peuvent être utilisés dans des piles solaires dont l'efficacité est améliorée.

Les substrats selon l'invention sont aussi utiles dans d'autres dispositifs opto-électroniques comme les dispositifs d'affichages à cristaux liquides du type afficheurs à matrices actives comportant des transistors en film mince TFT (Thin Film Transistor).

## TABLEAU 1

|  | Ex 1-1 | Ex 1-2 | Ex 1-3 | Ex 1-4 | Ex 1-5 |
|---|---|---|---|---|---|
| Résistance des couches ($\Omega/_{\square}$) | 11,1 | 12,0 | 12,2 | 12,4 | 12,9 |
| Cl (% en poids) | 0,10 | 0,10 | 0,08 | 0,05 | 0,03 |
| $T_L$ % avant trait. | 71,3 | 71,4 | 70,7 | 71,0 | 71,1 |
| $T_L$ % après trait. d'1 mn | 69,7 | 69,7 | 70,7 | 71,0 | 71,1 |
| $T_L$ % après trait. de 2 mn | 61,4 | 63,1 | 66,3 | 68,5 | 69,3 |
| $\Delta T_L$ % après trait de 2 mn | -9,9 | -8,3 | -4,4 | -2,5 | -1,8 |

EP 0 382 632 B1

TABLEAU 2

| Exemples | 2-1 | 2-2 | 2-3 | Témoin A | Témoin B |
|---|---|---|---|---|---|
| Résistance des couches ($\Omega$/□) | 51,0 | 29,5 | 11,5 | 10,7 | 7,0 |
| $T_L$ % avant trait. | 78,3 | 76,0 | 70,2 | 74,6 | 70,0 |
| $T_L$ % après trait. de 2 mn | 74,6 | 73,8 | 64,4 | 58,4 | 55,5 |
| Epaisseur couche $SnO_2$:F ($\mu$m) | 0,2 | 0,2 | 0,4 | 0,4 | 0,6 |
| Epaisseur couche $SnO_2$:Cl ($\mu$m) | 0,2 | 0,4 | 0,2 | | |
| Cl (% en poids) | 0,07 | 0,07 | 0,07 | | |
| $\Delta T_L$ % après trait de 2 mn | -3,4 | -2,2 | -5,8 | -16,2 | -14,5 |

**Revendications**

1.  Substrat électroconducteur transparent résistant aux traitements par plasma et comprenant un support de verre revêtu d'une première couche transparente d'oxyde métallique en oxyde d'étain dopé au fluor $SnO_2$:F ou en oxyde d'indium dopé à l'étain ITO, ladite première couche étant surmontée d'une seconde couche en oxyde d'étain caractérisé en ce que la seconde couche est dopée au chlore, ne contient pratiquement pas de fluor et a une teneur en poids de chlore comprise entre 0,1 et 0,03 %.

2.  Substrat selon la revendication 1, caractérisé en ce que l'épaisseur totale des deux couches est comprise entre 0,4 et 1 micromètre.

3.  Substrat selon l'une des revendications précédentes, caractérisé en ce que le support de verre est revêtu d'une première couche en $SnO_2$:F de 0,6 micromètre d'épaisseur et d'une seconde couche en $SnO_2$:Cl de 0,3 micromètre d'épaisseur.

4.  Substrat selon l'une des revendications 1 ou 2, caractérisé en ce que le support de verre est revêtu d'une première couche en $SnO_2$:F de 0,4 micromètre d'épaisseur et d'une seconde couche en $SnO_2$:Cl de 0,2 micromètre d'épaisseur.

5.  Substrat selon l'une des revendications 1 ou 2, caractérisé en ce que la première couche est en ITO et d'épaisseur 0,02 à 0,5 micromètre.

6.  Procédé d'obtention du substrat électroconducteur transparent selon l'une des revendications précédentes, caractérisé en ce qu'on dépose la seconde couche en $SnO_2$:Cl par C.V.D. à l'aide d'un mélange gazeux comprenant du tétrachlorure d'étain anhydre, de l'oxygène, du gaz azote et de la vapeur d'eau dont la proportion dans le mélange gazeux dose la faible teneur en chlore dans la couche.

7.  Procédé d'obtention selon la revendication 6, caractérisé en ce qu'on dépose la première couche lorsqu'elle est en $SnO_2$:F par C.V.D.

5

8. Procédé d'obtention selon la revendication 6, caractérisé en ce qu'on dépose la première couche lorsqu'elle est en ITO, par pulvérisation cathodique ou par pyrolyse de poudres.

9. Utilisation du substrat conforme à l'une des revendications 1 à 5 pour former une électrode transparente d'une pile solaire au silicium amorphe.

10. Utilisation du substrat conforme à l'une des revendications 1 à 5, dans un dispositif opto-électronique, notamment des dispositifs d'affichage à cristaux liquides du type afficheurs à matrices actives comportant des transistors en film mince TFT.

## Patentansprüche

1. Durchsichtiges elektrisch leitfähiges Substrat, das gegenüber Plasmabehandlungen beständig ist und einen Glasträger umfaßt, der mit einer ersten durchsichtigen Metalloxidschicht aus mit Fluor dotiertem Zinnoxid $SnO_2$:F oder mit Zinn dotiertem Indiumoxid ITO beschichtet ist, wobei die erste Schicht von einer zweiten Schicht aus Zinnoxid bedeckt ist, **dadurch gekennzeichnet, daß** die zweite Schicht mit Chlor mit einem Gewichtsanteil zwischen 0,1 und 0,03 % dotiert ist und praktisch kein Fluor enthält.

2. Substrat nach Anspruch 1, **dadurch gekennzeichnet, daß** die Gesamtdicke der beiden Schichten zwischen 0,4 und 1 Mikrometer liegt.

3. Substrat nach Anspruch 1 oder 2, **dadurch gekennzeichnet, daß** der Glasträger mit einer 0,6 Mikrometer dicken ersten Schicht aus $SnO_2$:F und mit einer 0,3 Mikrometer dicken zweiten Schicht aus $SnO_2$:Cl beschichtet ist.

4. Substrat nach Anspruch 1 oder 2, **dadurch gekennzeichnet, daß** der Glasträger mit einer 0,4 Mikrometer dicken ersten Schicht aus $SnO_2$:F und mit einer 0,2 Mikrometer dicken zweiten Schicht aus $SnO_2$:Cl beschichtet ist.

5. Substrat nach Anspruch 1 oder 2, **dadurch gekennzeichnet, daß** die erste Schicht aus ITO und 0,02 bis 0,5 Mikrometer dick ist.

6. Verfahren zur Herstellung des durchsichtigen elektrisch leitfähigen Substrats nach einem der vorhergehenden Ansprüche, **dadurch gekennzeichnet, daß** die zweite Schicht aus $SnO_2$:Cl durch CVD mittels eines Gasgemisches aufgebracht wird, das wasserfreies Zinntetrachlorid, Sauerstoff, Stickstoff und Wasserdampf enthält, durch dessen Anteil im Gasgemisch der geringe Chlorgehalt in der Schicht dosiert wird.

7. Herstellungsverfahren nach Anspruch 6, **dadurch gekennzeichnet daß** die erste Schicht, wenn sie aus $SnO_2$:F besteht, durch CVD aufgebracht wird.

8. Herstellungsverfahren nach Anspruch 6, **dadurch gekennzeichnet daß** die erste Schicht, wenn sie aus ITO besteht, durch Kathodenzerstäubung oder Pyrolyse von Pulvern aufgebracht wird.

9. Verwendung des Substrats nach einem der Ansprüche 1 bis 5 zur Bildung einer durchsichtigen Elektrode einer Solarzelle mit amorphem Silicium.

10. Verwendung des Substrats nach einem der Ansprüche 1 bis 5 in einer optoelektronischen Vorrichtung, insbesondere in Anzeigeeinrichtungen mit Flüssigkristallen vom Typ von An-zeigegeräten mit aktiven Matrizen, die Dünnschichttransistoren TFT enthalten.

## Claims

1. Transparent electrically conducting substrate, resistant to treatment by plasma, comprising a glass support coated with a first transparent metallic oxide film of tin oxide doped with fluorine $SnO_2$:F or of indium oxide doped with tin ITO, said first film being overlain by a second film of tin oxide, characterized in that the second film is doped with chlorine, contains virtually no fluorine and has a content by weight of chlorine of from 0.1 to 0.03%.

2. Substrate according to Claim 1, characterized in that the total thickness of both films is from 0.4 to 1 micrometre.

3. Substrate according to one of the preceding Claims, characterized in that the glass support is coated with a first film of $SnO_2$:F of 0.6 micrometre thickness and with a second film of $SnO_2$:Cl of 0.3 micrometre thickness.

4. Substrate according to one of Claims 1 or 2, characterized in that the glass support is coated with a first film of $SnO_2$:F of 0.4 micrometre thickness and with a second film of $SnO_2$:Cl of 0.2 micrometre thickness.

5. Substrate according to one of Claims 1 or 2, characterized in that the first film is of ITO and of thickness 0.02 to 0.5 micrometre.

6. Process for the production of the transparent electrically conducting substrate according to one of the preceding Claims, characterized in that the second film of $SnO_2$:Cl is deposited by C.V.D. by means of a gaseous mixture containing anhydrous tin tetrachloride, oxygen, nitrogen gas and water vapour, the proportion of which in the gaseous mixture meters the low content of chlorine into the film.

7. Production process according to Claim 6, characterized in that the first film, when it is of $SnO_2$:F, is deposited by C.V.D.

8. Production process according to Claim 6, characterized in that the first film, when it is of ITO, is deposited by cathodic sputtering or by pyrolysis of powders.

9. Use of the substrate according to one of Claims 1 to 5 for forming a transparent electrode of a solar cell comprising amorphous silicon.

10. Use of the substrate according to one of Claims 1 to 5 in an opto-electronic device, notably liquid crystal display devices of the active matrix display type, comprising thin film transistors TFT.